# EUROPEAN PATENT SPECIFICATION

(11) **EP 3 711 121 B1**
(45) Date of publication and mention of the grant of the patent: **23.11.2022**
(21) Application number: 17800539.3
(22) Date of filing: 17.11.2017
(51) Int. Cl.: H01S 5/14, H01S 5/065

(54) **EXTERNAL CAVITY DIODE LASER ARRANGEMENT**
DIODENLASERANORDNUNG MIT EXTERNEM RESONATOR
AGENCEMENT DE DIODE LASER À CAVITÉ EXTERNE

(43) Date of publication of application: 23.09.2020
(73) Proprietor: Cobolt AB, 171 54 Solna (SE)
(72) Inventor: KARLSSON, Håkan, 171 54 Solna (SE); ELGCRONA, Gunnar, 171 54 Solna (SE); RÅDMARK, Magnus, 171 54 Solna (SE)
(74) Representative: AWA Sweden AB
(86) International application number: PCT/EP2017/079624
(87) International publication number: WO 2019/096408

(56) References cited:
- EP-A2- 0 587 154
- EP-A2- 2 523 280
- US-A1- 2002 090 017
- US-A1- 2003 161 378

## Description

### Technical field

The present disclosure relates to diode laser arrangements in which optical feedback is provided in order to condition or modify the spectrum of the laser output.

### Background

Diode lasers can be made to emit spectrally narrowband radiation by increasing the lasing threshold for all laser modes except one or more modes in which lasing is desired. Diode lasers can also be made to emit narrowband radiation by decreasing the lasing threshold for one or more modes in which lasing is desired. It is also conceivable to provide narrowband laser radiation by filtering a comparatively broadband output from a laser module, e.g. using dielectric multilayer coatings.

The lasing threshold for one or more modes can be lowered by providing optical feedback to the laser element, wherein the optical feedback has spectral characteristics similar to the one or more modes for which the lasing threshold is to be lowered. Such optical feedback is sometimes called optical self-injection seeding or self-injection locking.

Optical feedback to the laser element can be provided by a volume Bragg grating (VBG). A VBG element, sometimes also referred to as a holographic optical element (HOE), is a structure comprising a volume Bragg grating that provides reflection at a desired (narrowband) wavelength. Output from the laser element is directed onto the VBG, and the reflection from the VBG is directed back as optical feedback into the laser element, which is thus caused to provide laser emission having similar spectral characteristics as the optical feedback.

As generally known in the art, a VBG is an optical element comprising a permanent refractive index variation that provides Bragg reflection, i.e. a phase grating. The phase grating is typically contained in a piece of high-quality glass, such as a block of silicate glass. Since VBGs, as such, are off-the-shelf components, no comprehensive description thereof is given herein.

For example, WO 2005/013439 discloses apparatus comprising a single-emitter broad-area multiple transverse mode laser diode and a VBG element for providing optical feedback to the laser diode. The VBG element receives light generated by the laser diode and reflects a narrow spectral band back into the laser. The feedback causes the laser diode to generate light having the spectral characteristics of the feedback.

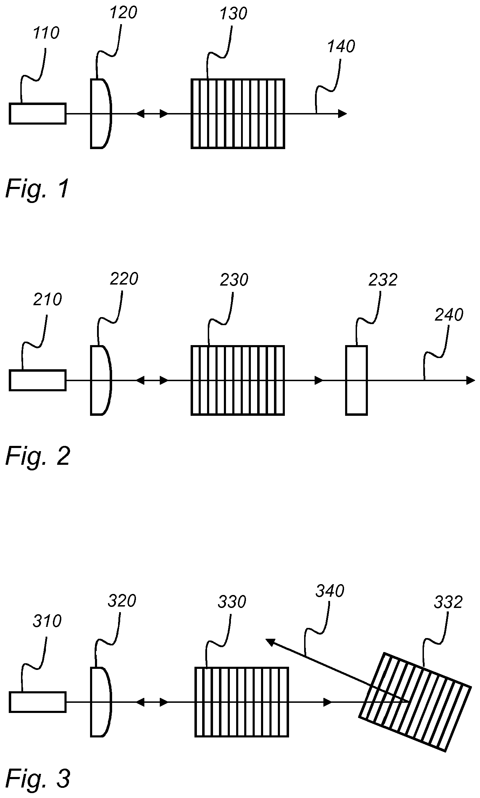

A prior art arrangement of the above kind is schematically shown in Figure 1. It comprises a diode laser element, beam shaping optics, and a VBG for providing optical feedback to the diode laser element. The VBG is designed to have partial reflectivity for the spectral band of interest, in order for part of the light in that spectral band impinging on the VBG to be reflected towards the laser element as feedback, and part of the light to be transmitted through the VBG as an output beam.

Another example of a diode laser that uses a VBG to provide optical feedback into the laser element is disclosed in WO 2016/042019. The main idea presented in WO 2016/042019 is to arrange the frequency-selective element (i.e. the VBG) external to the laser cavity and outside the main beam path comprising the majority of the laser radiation power. The external frequency-selective element is positioned in an additional feedback beam path that is different from the main beam path, wherein the radiant intensity incident to the frequency-selective element is controlled by intensity control means such that the additional feedback beam path has lower radiant intensity than the main beam path, thereby reducing thermal stress on the frequency-selective element.

Reference is further made to the following documents:
EP 2 523 280 A2 (POWERPHOTONIC) discloses an external cavity laser including a laser diode bar, collimating optics, a first deflector, a volume holographic grating, a second deflector, and an output coupler including a partially reflective surface. The laser also includes a quarter-wave plate and a polarising beam splitter.
US 2002/090017 A1 (HAGBERG) discloses a Littrow external cavity laser including a polarization beam splitter and a Faraday-rotator in the cavity.
US2003/161378 A1 (ZHANG GUANGZHI) 28 August 2003 discloses a Littman-Metcalf external cavity laser including a polarization beam splitter and polarization rotators in the cavity.

### Summary

The present invention is based on an understanding of some fundamental limitations of the prior art.

A diode laser arrangement of the kind disclosed in WO 2005/013439, and as schematically shown in Figure 1, stabilized using a VBG provides advantages in terms of spectral purity compared to standard diode lasers. However, the output beam has a considerable amount of energy outside of the spectral band of interest in the form of side modes. It should be noted that the VBG provides reflection only for a narrow spectral band, while other spectral components are transmitted by the VBG. Hence, while the VBG may provide suitable optical feedback to the laser element, there is no sideband suppression provided by the VBG. Some applications, for example Raman spectroscopy, benefit from light having higher spectral purity, particularly around the narrow-band main peak output from the laser, and there is thus a desire for some kind of side mode suppression.

Another drawback of an arrangement of the above kind is a difficulty in selecting the optimum reflectivity for the VBG within the spectral band of interest. While the center wavelength of the spectral band of interest may be tuned slightly by changing the temperature of the VBG, the magnitude of the reflectivity remains fixed once the VBG has been made. The amount of feedback to the diode element desired in order to obtain optimal seeding thereof may vary between applications and implementations, and may even vary between laser elements. It is thus a challenge in that type of arrangement to find the proper reflectivity, and a trial and error approach using different VBG designs is both awkward and expensive.

In order to suppress the side modes, some devices employ filtering of the laser output in order to achieve better side mode suppression ratio (SMSR). Such filtering could be provided by, for example, a dielectric multilayer filter placed in the path of the output beam. An exemplary embodiment of such arrangement is schematically shown in Figure 2. Dielectric filters are not very expensive, but suffer from being comparatively broadband. Even though some of the side mode energy is suppressed, there is still a considerable amount of output at wavelengths outside of the spectral band of interest.

An additional VBG (in addition to the VBG providing the optical feedback) could be used as a filter and would provide sufficiently narrowband filtering. An exemplary embodiment of such arrangement is schematically shown in Figure 3. However, the inventors have realized that such filter is difficult to align due to the strong angle dependency of its reflectivity, and there are also difficulties in spectrally matching the additional VBG filter with the peak output wavelength of the diode laser arrangement. Notably, in order to provide useful filtering of the output from the laser arrangement, the additional VBG must be spectrally matched with the VBG providing the optical feedback, and in most practical implementations both VBGs need to be actively temperature controlled. Furthermore, a VBG is comparatively expensive. Hence, although an arrangement as shown in Figure 3 could provide a useful and narrow-band output, yet further improvements are desirable.

The present invention is defined in appending independent claim 1. Preferred embodiment are given in the appending dependent claims.

The present invention provides a diode laser arrangement having an excellent side mode suppression ratio without relying on additional external filtering of the output beam. The present invention also provides for easy and convenient optimization of the optical feedback during assembly of the diode laser arrangement such that a desired balance between optical feedback and output beam is obtained.

More particularly, according to the invention which is disclosed in appending independent claim 1, there is provided a laser arrangement comprising a laser element; a volume Bragg grating, VBG, for providing optical feedback to the laser element along a beam path; a polarizing beam splitter, PBS, arranged in the beam path between the laser element and the VBG; and a polarization-modifying element arranged in the beam path between the PBS and the VBG element, said polarization-modifying element being a wave-plate configured to modify linearly polarized light into generally elliptically polarized light; wherein said polarization-modifying element is structured and arranged to alter a polarization state of light reflected from said VBG such that said PBS is operative to divide said light reflected from said VBG into a first portion that provides the optical feedback to the laser element and a second portion that provides an output beam from the laser arrangement. Embodiments of the inventive laser arrangement can thereby provide an output beam having spectral properties that are determined by the properties of the VBG. Side modes outside of the reflection band of the VBG are thus not present in the output beam. The invention thus provides a diode laser arrangement in which the output beam is entirely free from light that comes directly from the laser element. All light in the output beam is spectrally determined by the properties of the VBG and any light generated by the laser element outside the reflectivity band of the VBG is thereby effectively eliminated from the output beam.

Hence, in embodiments of the present invention, an output is provided by the PBS directly from the VBG, while light from the laser element is directed towards the VBG. The VBG functions as one of the end mirrors for a laser cavity or of the inventive diode laser arrangement, and the PBS is arranged such that light propagating from the laser element towards the VBG remains inside the cavity, while at least part of the light propagating in the other direction from the VBG towards the laser element is provided as an output beam from the cavity. The same VBG is thus used both for providing optical feedback to the laser element, and for spectrally filtering the output from the laser arrangement. In this manner, the output is derived directly from the VBG and is thus free from sidebands introduced by the laser element.

### Brief description of the drawings

Further details and embodiments of the invention will be given in the below detailed description, in which reference is made to the accompanying drawings on which:
Figure 1 schematically shows a prior art diode laser arrangement in which optical feedback is provided by means of a VBG;
Figure 2 schematically shows a diode laser arrangement similar to that shown in Figure 1, said arrangement not being claimed, but in which the output beam is filtered using a dielectric filter;
Figure 3 schematically shows a diode laser arrangement similar to that shown in Figure 1, said arrangement not being claimed, but in which the output beam is filtered using an additional VBG;
Figure 4 schematically shows an embodiment of the present invention, in which an output beam is extracted by reflection from the PBS;
Figure 5 schematically shows an embodiment of the present invention, in which an output beam is extracted by transmission through the PBS;
Figure 6 shows spectral characteristics of the diode laser arrangements, which are not part of the present invention, shown in Figures 1-3; and
Figure 7 shows spectral characteristics of an embodiment of the inventive diode laser arrangement.

### Detailed description

Referring to Figure 1, there is schematically shown a prior art diode laser arrangement of the kind disclosed in WO 2005/013439. A diode laser element 110 has a spectral gain profile within which optical radiation is generated. Light emitted by the diode laser element is collected by beam-shaping optics 120 and then directed towards a volume Bragg grating, VBG, 130. The VBG reflects part of the light within a predetermined spectral band back towards the diode laser element 110, such that the laser element is caused to generate light within that spectral band. Since only part of the light within the predetermined spectral band is reflected by the VBG, a substantial fraction of light within the predetermined spectral band is transmitted through the VBG and can be used as an output 140 from the diode laser arrangement.

It should also be noted that the VBG is generally transmissive for light having a wavelength outside the predetermined spectral band. This means that the peak wavelength in the output, as determined by the spectral band of the VBG, is surrounded by side-modes excited by the laser element.

Figure 2 shows another diode laser arrangment, which is not part of the present invention as disclosed in the claims.

The arrangement of Figure 2 is similar to that of Figure 1, except that the output is filtered using a dielectric filter 232 in order to suppress side modes (i.e. improve the SMSR). A diode laser element 210 has a spectral gain profile within which optical radiation is generated. Light emitted by the diode laser element is collected by beam-shaping optics 220 and then directed towards a volume Bragg grating, VBG, 230. The VBG reflects part of the light within a predetermined spectral band back towards the diode laser element 210, such that the laser element is caused to generate light within that spectral band. Since only part of the light within the predetermined spectral band is reflected by the VBG, a substantial fraction of light within the predetermined spectral band is transmitted through the VBG and can be used as an output 240 from the diode laser arrangement. The dielectric filter 232 is placed in the beam path after the VBG with the purpose of "cleaning" the output from unwanted side-modes. While the arrangement of Figure 2 provides some improvement in terms of side-mode suppression, it is limited by the comparatively broad spectral width of dielectric filters. Again, this means that the peak wavelength in the output, as determined by the spectral band of the VBG, is surrounded by side-modes excited by the laser element.

Figure 3 shows another diode laser arrangement, which is not part of the present invention as disclosed in the claims, in which the output is filtered in order to suppress side-modes. A diode laser element 310 has a spectral gain profile within which optical radiation is generated. Light emitted by the diode laser element is collected by beam-shaping optics 320 and then directed towards a volume Bragg grating, VBG, 330. The VBG 330 reflects part of the light within a predetermined spectral band back towards the diode laser element 310, such that the laser element is caused to generate light within that spectral band. Since only part of the light within the predetermined spectral band is reflected by the VBG, a substantial fraction of light within the predetermined spectral band is transmitted through the VBG 330 and can be used as an output 340 from the diode laser arrangement. In the arrangement shown in Figure 3, a second VBG 332 is used for providing the filtering, in addition to the first VBG 330 providing the optical feedback to the laser element. By carefully matching the spectral band reflected by the first VBG 330 to the spectral band reflected by the second VBG 332, very high side-mode suppression can be obtained. The first VBG 330 provides feedback to the laser element in order to condition the generation of light therein, and even though the first VBG will transmit the side-modes excited by the laser element, the second VBG 332 effectively filters out those side-modes by only reflecting, as an output 340 from the diode laser arrangement, light within the predetermined spectral band.

While the arrangement of Figure 3 has the potential of providing an excellent output in terms of side-mode suppression, it has some associated drawbacks that could make it less interesting in practice. As will be understood, in order for the arrangement to perform as desired, the spectral bands of reflection for the first and the second VBG must be carefully matched. If the second VBG does not reflect precisely the same spectral band as that provided by the first VBG as optical feedback to the laser element, the arrangement will fail or underperform. Hence, the arrangement of Figure 3 has the absolute constraint that both VBGs must reflect the same spectral band. However, it is difficult to fulfil this constraint over typical operating conditions. Firstly, the second VBG operates under non-normal incidence, and there is typically a very narrow angle acceptance in order to maintain reflectivity for the predetermined spectral band. Moreover, the angle acceptance decreases as the spectral bandwidth of the VBG is made narrower and as the angle of incidence increases. In practice, this very limited angle acceptance also leads to the requirement that the output beam should be transversally single mode and well-collimated. Secondly, the spectral band of a VBG is temperature sensitive, which means that both VBGs must be carefully and jointly temperature controlled. Furthermore, VBGs are comparatively costly and the use of a second unit adds undesirably to the overall cost of the arrangement. To some extent, the above challenges can be addressed by tuning the angle of incidence on the VBG. For a collimated and transversally single-mode laser beam and an angle of incidence on the VBG of about 20-30 degrees, the reflected wavelength can be tuned slightly by changing the angle of incidence. The two VBGs could then be allowed to differ slightly with respect to the nominal wavelength for which they are designed. However, once the components have been fixed in position during assembly, such angle tuning will no longer be available.

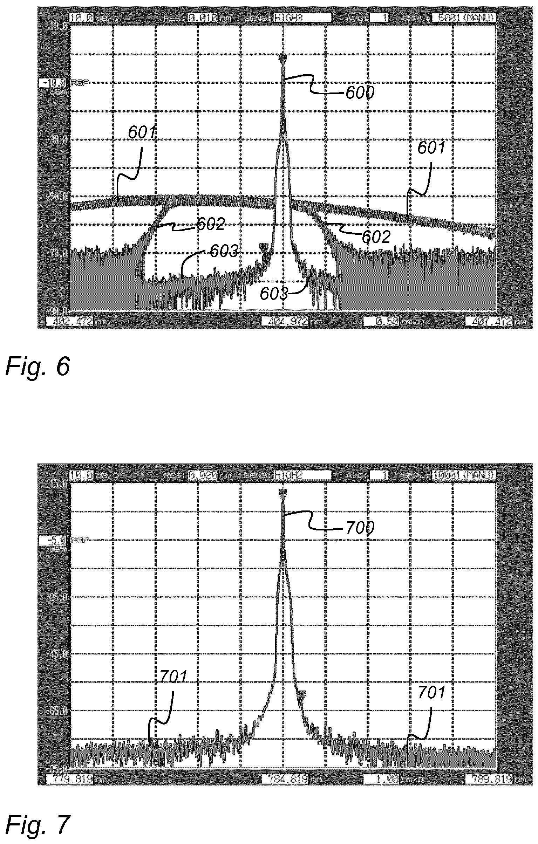

Figure 6 shows the spectral characteristic of the optical output of the arrangements shown in Figures 1-3, respectively. The peak output, which is the same for all three arrangements, can be seen at reference numeral 600. While the output has a narrow peak centered at the same wavelength for all three arrangements of Figures 1-3, it is evident that the side-mode behavior is very different between the arrangements. The side-modes are shown at reference numerals 601, 602 and 603, respectively.

The side-modes of the arrangement shown in Figure 1, for which there is no additional filtering but the output is merely conditioned by optical feedback into the laser element from the VBG, there is a broad background of side-mode radiation shown at 601. This background corresponds to the gain profile of the laser element.

Some of this side-mode background is removed in the arrangement of Figure 2, which has a side-mode background as shown at 602 in Figure 6. The width of the side-mode background 602 corresponds to the transmission window of the dielectric filter 232 shown in Figure 2. Even though the width of the side-mode background has been reduced, the level of the background is still the same around the peak 600. It is also evident from Figure 6 that the side-mode background is still rather wide compared to the peak 600.

The spectral characteristics of the arrangement of Figure 3 is also shown in Figure 6. The peak 600 is still the same as for the arrangements of Figures 1 and 2, but the side-mode background is drastically reduced, as shown at 603. In fact, any side-mode background is almost completely eliminated by the use of the second VBG 332.

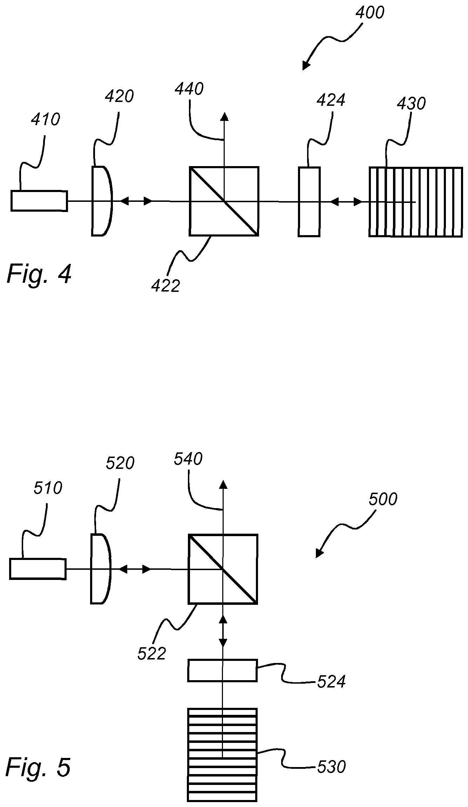

The spectral characteristics of an embodiment of the present invention is shown in Figure 7. The set-up used for measuring the spectral characteristics was the one shown in Figure 4. As evident, the side-mode suppression is just as effective as in the arrangement shown in Figure 3. A narrow peak of the output is shown at reference numeral 700 without any side-modes around the same. There is only some low-level noise present outside the peak 700, as shown at 701.

A first embodiment of the invention is schematically shown in Figure 4. A laser element 410 has a gain profile within which optical radiation is generated. Light emitted by the laser element is collected by beam-shaping optics 420 and directed towards a polarizing beam splitter, PBS, 422. In the embodiment shown, the polarization of light generated by the laser element 410 is linear and in such orientation that it passes through the PBS 422. However, in other embodiments there may be one or more polarizing-modifying elements provided between the laser element 410 and the PBS 440 in order to provide a polarization such that the generated light passes through the PBS 422.

After having passed, i.e. transmitted through, the PBS 422, light passes a polarizing-modifying element in the form of a quarter wave-plate 424. The quarter wave-plate modifies the linearly polarized light generated by the laser element 410 and transmitted through the PBS 422 into generally elliptically polarized light. After having passed the quarter wave-plate, the light impinges upon a volume Bragg grating, VBG, 430. The VBG 430 has a Bragg structure that is effective to reflect light within a narrow and predetermined spectral band back towards the quarter wave-plate. Light outside of the predetermined spectral band passes through the VBG 430 and is lost from the arrangement. It is thus typically desired to structure the VBG for high reflectivity at the desired wavelength peak, and in this case the reflectivity is about 95%. Yet higher reflectivity, approaching 100%, may undesirably lead to side-modes appearing in the reflected light from the VBG and should normally be avoided.

The light reflected from the VBG 430 then passes the quarter wave-plate 424 again, and is modified back into linearly polarized light but in another orientation compared to the light originally generated by the laser element 410. This means that when the light impinges upon the PBS 422 after having been reflected from the VBG 430 and modified by the quarter wave-plate 424, some light will be transmitted towards the laser element 410 and some light will be reflected out as an output beam 440. It should be noted that the light that is transmitted back towards the laser element 410 then has the same polarization state as the light originally generated by the laser element. This transmitted light returns into the laser element 410 and conditions it to generate light having similar spectral properties, i.e. spectral properties similar to the reflection band of the VBG.

In particular, the light reflected by the PBS 422 into the output beam 440 is entirely made up of light that has just been reflected from the VBG 430 and thus contains no light that comes directly from the laser element 410. In this manner, the output beam 440 is free from side-modes generated by the laser element 410 outside the reflection band of the VBG 430. In other words, the spectral properties of the output beam are determined by the properties of the VBG.

The embodiment shown in Figure 4 thus provides a spectrally very clean output beam 440 using only a single VBG, while at the same time allowing spectrally selective feedback into the laser element.

Another embodiment of the present invention is schematically shown in Figure 5. A laser element 510 has a gain profile within which optical radiation is generated. Light emitted by the laser element is collected by beam-shaping optics 520 and directed towards a polarizing beam splitter, PBS, 522. In the embodiment shown, the polarization of light generated by the laser element 510 is linear and in such orientation that it is reflected by the PBS 522. However, in other embodiments there may be one or more polarizing-modifying elements provided between the laser element 510 and the PBS 522 in order to provide a polarization such that the generated light is reflected by the PBS 522.

After having passed, i.e. been reflected by, the PBS 522, light passes a polarizing-modifying element in the form of a quarter wave-plate 524. The quarter wave-plate modifies the linearly polarized light generated by the laser element 510 and reflected by the PBS 522 into generally elliptically polarized light. After having passed the quarter wave-plate, the light impinges upon a volume Bragg grating, VBG, 530. The VBG 530 has a Bragg structure that is effective to reflect light within a narrow and predetermined spectral band back towards the quarter wave-plate. Light outside of the predetermined spectral band passes through the VBG 530 and is lost from the arrangement. It is thus typically desired to structure the VBG for maximum reflectivity at the desired wavelength peak, and in this case the reflectivity is about 95%. Yet higher reflectivity, approaching 100%, may undesirably lead to side-modes appearing in the reflected light from the VBG and should normally be avoided.

The light reflected from the VBG 530 then passes the quarter wave-plate 524 again, and is modified back into linearly polarized light but in another orientation compared to the light originally generated by the laser element 510. This means that when the light impinges upon the PBS 522 after having been reflected from the VBG 530 and modified by the quarter wave-plate 524, some light will be reflected towards the laser element 510 and some light will be transmitted out as an output beam 540. It should be noted that the light that is reflected back towards the laser element 510 then has the same polarization state as the light originally generated by the laser element. This reflected light returns into the laser element 510 and conditions it to generate light having similar spectral properties, i.e. spectral properties similar to the reflection band of the VBG.

In particular, the light transmitted through the PBS 522 into the output beam 540 is entirely made up of light that has just been reflected from the VBG 530 and thus contains no light that comes directly from the laser element 510. In this manner, the output beam 540 is free from side-modes generated by the laser element 510 outside the reflection band of the VBG 530. In other words, the spectral properties of the output beam are determined by the properties of the VBG.

The embodiment shown in Figure 5 thus provides a spectrally very clean output beam 540 using only a single VBG, while at the same time allowing spectrally selective feedback into the laser element.

An advantage of the present invention is that the polarization-modifying element, i.e. the quarter wave-plates 424 and 524 in Figures 4 and 5, can be oriented during assembly of the laser arrangement to provide a desired balance between feedback and output. By rotating (the optical axis of) the quarter wave-plate, the polarization state of light returning to the PBS after having been reflected by the VBG can be varied, leading to a correspondingly varied fraction of light being transmitted/reflected by the PBS. In embodiments that comprise beam-shaping optics 420/520, about 5%-20% and preferably about 10% of the light reflected back from the VBG (reflectivity -95%) is preferably provided as optical feedback towards the laser element. If there is no beam-shaping optics, beam divergence will cause less of the optical feedback to actually enter into the laser element, thus typically requiring more light to be fed back towards the laser element. This possibility to vary the fraction of light being transmitted/reflected by the PBS is particularly advantageous considering the fact that magnitude of the reflectivity of the VBGs cannot be altered once they have been made.

The laser element in embodiments of the present invention is preferably an edge emitting single- or multimode diode laser. However, embodiments using vertical-cavity surface-emitting lasers, VCSELs, are also contemplated.

### Conclusion

A laser arrangement is disclosed, comprising a laser element; a volume Bragg grating (VBG) configured to provide optical feedback to the laser element along a beam path, a polarizing beam splitter (PBS) arranged in the beam path between the laser element and the VBG; and a polarization-modifying element arranged in the beam path between the PBS and the VBG element, said polarization-modifying element being a wave-plate configured to modify linearly polarized light into generally elliptically polarized light;
wherein said polarization-modifying element is structured and arranged to alter a polarization state of light reflected from the VBG such that an output beam can be provided by the PBS comprising light that has been reflected from the VBG. Thereby, the spectral properties of the output beam are determined by the properties of the VBG.

In some embodiments, the PBS is oriented to maximize transmission of linearly polarized light that is emitted from the laser element, as illustrated in Figure 4. In other embodiments, the PBS is oriented to maximize reflection of linearly polarized light that is emitted from the laser element, as illustrated in Figure 5.

By providing an output beam comprising light that has been reflected from the VBG, a spectrally clean output with an excellent side-mode suppression ratio is obtained. The spectral properties of the output beam are determined by the properties of the VBG. Since side modes outside of the spectral band of the VBG are not present in the output beam, embodiments of the present invention are expected to be particularly attractive for use in low wavenumber Raman spectroscopy.

Embodiments of the present invention could thus provide a spectrally narrow-band output using a single VBG. The requirement in other arrangements of having two separate VBGs of different reflectivities that are spectrally matched is eliminated. Furthermore, the amount of optical feedback to the laser element can be freely selected by rotating the quarter wave-plate into a desired orientation before fixing it during assembly of the laser arrangement.

## Claims

1. A laser arrangement (400; 500), comprising
a laser element (410; 510);
a volume Bragg grating, VBG, (430; 530) configured to provide optical feedback to the laser element along a beam path;
a polarizing beam splitter, PBS, (422; 522) arranged in the beam path between the laser element and the VBG; and
a polarization-modifying element (424; 524) arranged in the beam path between the PBS and the VBG element, said polarization-modifying element being a wave-plate configured to modify linearly polarized light into generally elliptically polarized light;
wherein said polarization-modifying element is structured and arranged to alter a polarization state of light reflected from said VBG such that said PBS is operative to divide said light reflected from said VBG into a first portion that provides the optical feedback to the laser element and a second portion that provides an output beam (440; 540) from the laser arrangement.

2. The laser arrangement of claim 1, wherein the polarization-modifying element is a quarter wave-plate.

3. The laser arrangement of claim 1 or 2, wherein the laser element is an edge-emitting diode laser.

4. The laser arrangement of claim 1 or 2, wherein the laser element is a vertical-cavity surface-emitting laser, VCSEL.

5. The laser arrangement of any one of the preceding claims, wherein the PBS and the polarization-modifying element are structured and arranged to provide the output beam by the PBS transmitting light reflected from the VBG and to provide the feedback to the laser element by the PBS reflecting light reflected from the VBG.

6. The laser arrangement of any one of claims 1-4, wherein the PBS and the polarization-modifying element are structured and arranged to provide the output beam by the PBS reflecting light reflected from the VBG and to provide the feedback to the laser element by the PBS transmitting light reflected from the VBG.

7. The laser arrangement of any one of the preceding claims, further comprising a second polarization-modifying element positioned between the laser element and the PBS.

8. The laser arrangement of any one of the preceding claims, further comprising beam shaping optics positioned between the laser element and the PBS.

9. The laser arrangement of claim 8, wherein said polarization-modifying element is structured and arranged to alter the polarization state of light reflected from said VBG such that said first portion providing optical feedback to the laser element includes 5% - 20%, and preferably 8% - 12%, of the power of light reflected from said VBG.

## Patentansprüche

1. Laseranordnung (400; 500), die Folgendes umfasst:
ein Laserelement (410; 510);
ein Volumen-Bragg-Gitter, VBG, (430; 530), das zum Liefern einer optischen Rückkopplung an das Laserelement entlang eines Strahlpfades konfiguriert ist;
einen Polarisationsstrahlteiler, PBS, (422; 522), der in dem Strahlpfad zwischen dem Laserelement und dem VBG angeordnet ist; und
ein Polarisationsmodifikationselement (424; 524), das in dem Strahlpfad zwischen dem PBS und dem VBG-Element angeordnet ist, wobei das Polarisationsmodifikationselement eine Wellenplatte ist,
die zum Modifizieren von linear polarisierten Licht zu allgemein elliptischem polarisierten Licht konfiguriert ist,
wobei das Polarisationsmodifikationselement zum Verändern eines Polarisationszustands von von dem VBG reflektiertem Licht derart strukturiert und angeordnet ist, dass der PBS zum Aufteilen des von dem VBG reflektierten Lichts in einen ersten Teil, der die optische Rückkopplung zu dem Laserelement bereitstellt, und einen zweiten Teil, der einen Ausgabestrahl (440; 540) von der Laseranordnung bereitstellt, funktionsfähig ist.

2. Laseranordnung nach Anspruch 1, wobei das Polarisationsmodifikationselement eine Viertelwellenlängenplatte ist.

3. Laseranordnung nach Anspruch 1 oder 2, wobei das Laserelement ein Kantenemissionsdiodenlaser ist.

4. Laseranordnung nach Anspruch 1 oder 2, wobei das Laserelement ein Vertikalkavitätsoberflächenemissionslaser, VCSEL, ist.

5. Laseranordnung nach einem der vorhergehenden Ansprüche, wobei der PBS und das Polarisationsmodifikationselement zum Bereitstellen des Ausgabestrahls dadurch, dass der PBS von dem VBG reflektiertes Licht transmittiert, und zum Liefern der Rückkopplung an das Laserelement dadurch, dass der PBS von dem VBG reflektiertes Licht reflektiert, strukturiert und angeordnet sind.

6. Laseranordnung nach einem der Ansprüche 1-4, wobei der PBS und das Polarisationsmodifikationselement zum Bereitstellen des Ausgabestrahls dadurch, dass der PBS von dem VBG reflektiertes Licht reflektiert, und zum Liefern der Rückkopplung an das Laserelement dadurch, dass der PBS von dem VBG reflektiertes Licht transmittiert, strukturiert und angeordnet sind.

7. Laseranordnung nach einem der vorhergehenden Ansprüche, die ferner ein zweites Polarisationsmodifikationselement umfasst, das zwischen dem Laserelement und dem PBS positioniert ist.

8. Laseranordnung nach einem der vorhergehenden Ansprüche, die ferner eine Strahlformungsoptik umfasst, die zwischen dem Laserelement und dem PBS positioniert ist.

9. Laseranordnung nach Anspruch 8, wobei das Polarisationsmodifikationselement zum Verändern des Polarisationszustands von von dem VBG reflektiertem Licht derart strukturiert und angeordnet ist, dass der erste Teil, der die optische Rückkopplung an das Laserelement liefert, 5 % - 20 % und bevorzugt 8 % - 12 % der Leistung von von dem VBG reflektiertem Licht beinhaltet.

## Revendications

1. Agencement laser (400 ; 500), comprenant
un élément laser (410 ; 510) ;
un réseau de Bragg en volume, VBG, (430 ; 530) configuré pour fournir une rétroaction optique à l'élément laser le long d'un trajet de faisceau ;
un diviseur de faisceau polarisant, PBS (422 ; 522) agencé dans le trajet de faisceau entre l'élément laser et le VBG ; et
un élément modificateur de polarisation (424 ; 524) agencé dans le trajet de faisceau entre le PBS et l'élément VBG, ledit élément modificateur de polarisation étant une lame d'onde configurée pour modifier la lumière polarisée linéairement en une lumière polarisée généralement elliptiquement ;
ledit élément modificateur de polarisation étant structuré et agencé pour modifier un état de polarisation de la lumière réfléchie par ledit VBG de sorte que ledit PBS est opérationnel pour diviser ladite lumière réfléchie par ledit VBG en une première partie qui fournit la rétroaction optique à l'élément laser et une seconde partie qui fournit un faisceau de sortie (440 ; 540) à partir de l'agencement laser.

2. Agencement laser selon la revendication 1, l'élément modificateur de polarisation étant une lame quart d'onde.

3. Agencement laser selon la revendication 1 ou 2, l'élément laser étant un laser à diode à émission latérale.

4. Agencement laser selon la revendication 1 ou 2, l'élément laser étant un laser à émission de surface à cavité verticale, VCSEL.

5. Agencement laser selon l'une quelconque des revendications précédentes, le PBS et l'élément modificateur de polarisation étant structurés et agencés pour fournir le faisceau de sortie au moyen du PBS transmettant la lumière réfléchie par le VBG et pour fournir la rétroaction à l'élément laser au moyen du PBS réfléchissant la lumière réfléchie par le VBG.

6. Agencement laser selon l'une quelconque des revendications 1 à 4, le PBS et l'élément modificateur de polarisation étant structurés et agencés pour fournir le faisceau de sortie au moyen du PBS réfléchissant la lumière réfléchie par le VBG et pour fournir la rétroaction à l'élément laser au moyen du PBS transmettant la lumière réfléchie par le VBG.

7. Agencement laser selon l'une quelconque des revendications précédentes, comprenant en outre un second élément modificateur de polarisation positionné entre l'élément laser et le PBS.

8. Agencement laser selon l'une quelconque des revendications précédentes, comprenant en outre une optique de mise en forme de faisceau positionnée entre l'élément laser et le PBS.

9. Agencement laser selon la revendication 8, ledit élément modificateur de polarisation étant structuré et agencé pour modifier l'état de polarisation de la lumière réfléchie par ledit VBG de telle sorte que ladite première partie fournissant une rétroaction optique à l'élément laser inclut 5 % à 20 %, et de préférence 8 % à 12 %, de la puissance de la lumière réfléchie par ledit VBG.
